# EUROPEAN PATENT APPLICATION

(11) **EP 4 806 709 A1**
(43) Date of publication of application: **16.09.2026**
(21) Application number: 26163779.7
(22) Date of filing: 10.03.2026
(51) Int. Cl.: B60L 3/00, B60L 3/12, B60L 50/64, B60L 58/10, B60L 58/20, H01M 10/48

(54) **BATTERY MANAGEMENT SYSTEM**

(30) Priority: 12.03.2025 US 202563770815 P; 04.03.2026 US 202619556692
(71) Applicant: Analog Devices International Unlimited Company, Co. Limerick (IE)
(72) Inventor: HASSAN, Khaled, Co. Limerick (IE); HUI, Wan-Laan, Wilmington, 01887 (US); Karakoyunlu, Deniz, Wilmington, 01887 (US)
(74) Representative: Yang, Shu

(57) **Abstract**

A battery management system for managing both a high-voltage traction battery and a low-voltage electronics battery can include a network manager circuit. The network manager circuit can include a wireless transceiver, which can be configured to communicate wirelessly with a high-voltage battery monitor coupled to the high-voltage traction battery. The network manager circuit can also include a first wired interface, which can be configured to communicate with a low-voltage battery monitor coupled to the low-voltage electronics battery. The network manager circuit can also include a second wired interface, which can be configured to communicate with a battery management system host controller.

## Description

### CLAIM OF PRIORITY

This patent application claims the benefit of priority of U.S. Provisional Patent Application 63/770,815, entitled "MONITORING LOW VOLTAGE BATTERY CELL MODULE WITH THE NETWORK MANAGER OF THE WIRELESS BATTERY MANAGEMENT SYSTEM," filed on March 12, 2025, and U.S. Non-Provisional Patent Application 19/556,692, entitled "BATTERY MANAGEMENT SYSTEM", filed on March 4, 2026, which are hereby incorporated by reference herein in their entirety.

### TECHNICAL FIELD

The present disclosure relates to battery management systems, and more particularly, but not by way of limitation, to a network manager circuit that can communicate wirelessly with a high-voltage traction battery monitor and communicate over wired interfaces with a low-voltage electronics battery monitor and a battery management system host controller.

### BACKGROUND

Electric vehicles can include a high-voltage traction battery for powering a drivetrain and a low-voltage electronics battery for powering electronic control units and other vehicle subsystems. A battery management system can be used to monitor and manage battery cells, such as by measuring voltage, current, and temperature parameters and by performing cell balancing operations. In some electric vehicles, the high-voltage traction battery and the low-voltage electronics battery can be housed together within an automotive battery enclosure.

### SUMMARY

In an example, a battery management system for managing both a high-voltage traction battery and a low-voltage electronics battery can include a network manager circuit. The network manager circuit can include a wireless transceiver, which can be configured to communicate wirelessly with a high-voltage battery monitor coupled to the high-voltage traction battery. The network manager circuit can also include a first wired interface, which can be configured to communicate with a low-voltage battery monitor coupled to the low-voltage electronics battery. The network manager circuit can also include a second wired interface, which can be configured to communicate with a battery management system host controller.

In an example, a method of operating a battery management system for managing both a high-voltage traction battery and a low-voltage electronics battery can include communicating, such as using a wireless transceiver included in a network manager circuit, wirelessly with a high-voltage battery monitor which can be coupled to the high-voltage traction battery. The method can also include communicating, such as using a first wired interface included in the network manager circuit, with a low-voltage battery monitor which can be coupled to the low-voltage electronics battery. The method can also include communicating, such as using a second wired interface included in the network manager circuit, with a battery management system host controller.

In an example, a battery management system for managing both a high-voltage traction battery and a low-voltage electronics battery can include a network manager circuit which can be included in or in combination with an automotive battery enclosure including the high-voltage traction battery and the low-voltage electronics battery. The network manager circuit can include a wireless transceiver, which can be configured to communicate wirelessly with a high-voltage battery monitor coupled to the high-voltage traction battery. The network manager circuit can include a first wired interface, which can be configured to communicate with a low-voltage battery monitor coupled to the low-voltage electronics battery. The network manager circuit can include a second wired interface, which can be configured to communicate with a battery management system host controller. The battery management system can include the battery management system host controller which can be external to the automotive battery enclosure, where the second wired interface can pass through the automotive battery enclosure.

### BRIEF DESCRIPTION OF THE DRAWINGS

In the drawings, which may not be drawn to scale, like numerals may describe substantially similar components throughout one or more of the views. Like numerals having different letter suffixes may represent different instances of substantially similar components. The drawings illustrate generally, by way of example but not by way of limitation.
FIG. 1 shows a block diagram of an example of portions of a battery management system 100.
FIG. 2 shows a block diagram of an example of portions of the network manager circuit and portions of an environment in which the network manager circuit can be used.
FIG. 3 shows an example of portions of a method for operating a battery management system.
FIG. 4 is a block diagram of an example of portions of a machine upon which one or more portions of the present disclosure may be implemented.

### DETAILED DESCRIPTION

Battery management systems can use wired connections or wireless connections to communicate between battery monitoring circuits and a host controller. In a wireless battery management system, wireless nodes can be coupled to respective battery modules to collect data from battery cells and wirelessly transmit the data to other components in the system.

The present inventors have recognized, among other things, that managing both a high-voltage traction battery and a low-voltage electronics battery within a wireless battery management system can present challenges. In some electric vehicles, a high-voltage traction battery and a low-voltage electronics battery can be housed together within an automotive battery enclosure, such as a metal enclosure that can form part of or be mounted to a structural framework of the vehicle. When both the high-voltage traction battery and the low-voltage electronics battery are located within the automotive battery enclosure, it can be desirable to manage both batteries using a common battery management system within the enclosure while maintaining a single wired interface passing through the enclosure to a host controller external to the enclosure.

The high-voltage traction battery can include one or more high-voltage traction battery modules, which can include a high-voltage battery monitor that communicates wirelessly to the battery management system. The wireless high-voltage battery monitors can communicate with a network manager circuit, which can be located at least partially inside the automotive battery enclosure. This network manager circuit can also communicate with a host controller. Adding a dedicated wireless node for the low-voltage electronics battery (e.g., to communicate with the network manager circuit) can consume wireless network capacity that could otherwise be used for high-voltage battery monitoring. The low-voltage electronics battery can have different reporting rate specification and/or different control specifications (e.g., functional safety) than the high-voltage traction battery, such as can include faster data reporting intervals and faster response times for actuating switches to isolate the low-voltage electronics battery during a fault condition. Using a separate wireless node for the low-voltage electronics battery can also add a processor to the system, increase power consumption, increase a cost, or increase a physical size of the battery management system. A wireless communication safety concept can also become more complicated when both low-voltage and high-voltage battery data are transmitted over the wireless network.

Accordingly, the present inventors have recognized, among other things, that it can be desirable to use the network manager circuit to communicate with a low-voltage battery monitor over a wired connection. For example, the network manager circuit can be at least partially within the automotive battery enclosure, the low-voltage battery module, or both. The network manager circuit can provide one point of contact for the host controller to monitor and/or control one or more (e.g., both) of the low-voltage electronics battery and the high-voltage traction battery, such as through a wired connection, such as can pass through the automotive battery enclosure. The network manager circuit may operate using a reference potential level that matches or is close to a reference potential level of the low-voltage electronics battery (e.g., at 0 volts (e.g., automotive ground), within 15 volts of automotive ground). One or more of the high-voltage battery monitors may operate at a reference potential level that differs significantly from automotive ground (e.g., 100 volts, 200 volts, 300 volts, or more). This can make it desirable to electrically couple the network manager circuit to the low-voltage electronics battery (e.g., using a wired connection to the low-voltage electronics battery), such as because lower electrical potential differences are experienced by circuit components.

In an example, a battery management system can include a network manager circuit located within the automotive battery enclosure that can serve as a bridge between a wireless communication domain and a wired communication domain. The network manager circuit can include a wireless transceiver configured to communicate wirelessly with one or more high-voltage battery monitors coupled to the high-voltage traction battery using electromagnetic signals within the automotive battery enclosure, a first wired interface configured to communicate with a low-voltage battery monitor coupled to the low-voltage electronics battery, and a second wired interface configured to communicate with a battery management system host controller external to the automotive battery enclosure. The second wired interface can pass through the automotive battery enclosure to reach the host controller. The network manager circuit can collect data from the high-voltage traction battery via the wireless transceiver and collect data from the low-voltage electronics battery via the first wired interface, and can provide both sets of data to the host controller through the second wired interface. In this way, the host controller can receive both high-voltage and low-voltage battery management data through a single interface without requiring a separate system or interface for the low-voltage electronics battery. The network manager circuit can also be configured to locally control a low-voltage battery switch, such as through a third wired interface to a switch driver, which can allow for faster response to fault conditions without requiring intervention from the host controller.

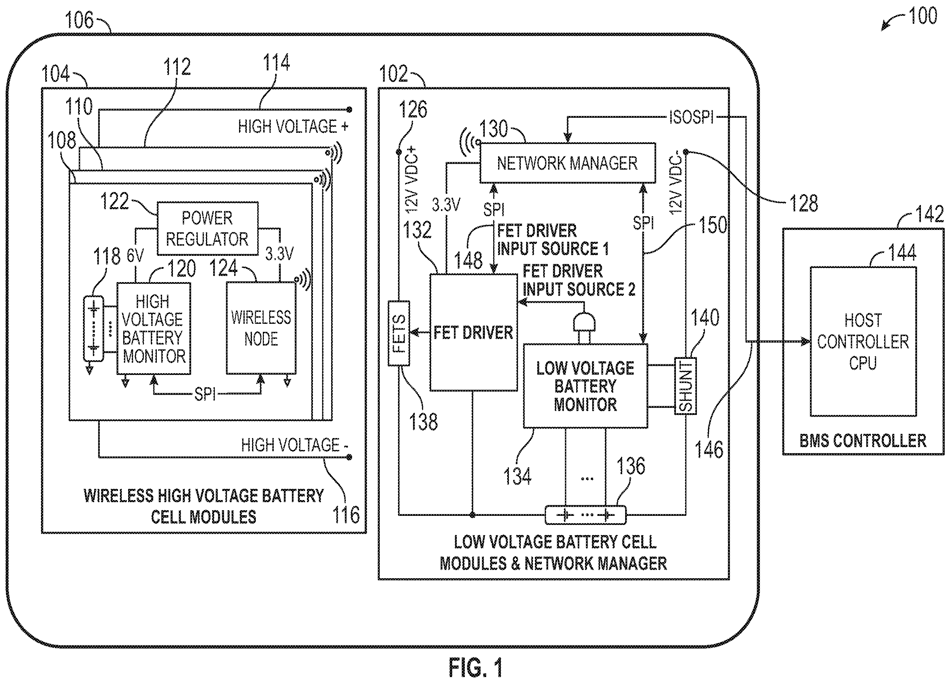

FIG. 1 shows a block diagram of an example of portions of a battery management system 100. FIG. 1 shows that the battery management system 100 can include an automotive battery enclosure 106, a high-voltage traction battery 104, a low-voltage electronics battery 102, one or more wireless high-voltage battery cell modules (e.g., included in and/or forming the high-voltage traction battery 104), and a BMS host controller 142.

The automotive battery enclosure 106 can be a metal enclosure, such as can include an aluminum enclosure, a steel enclosure, or an enclosure formed from another conductive material. The automotive battery enclosure 106 can form part of or be mounted to a structural framework of a vehicle. The automotive battery enclosure 106 can substantially shield an area outside the automotive battery enclosure 106 from electromagnetic signals transmitted and received within the automotive battery enclosure 106. For example, the automotive battery enclosure 106 can attenuate electromagnetic signals passing through the enclosure, such as can reduce interference from external sources and can help contain wireless signals within the automotive battery enclosure 106. The automotive battery enclosure 106 can house one or more of the high-voltage traction battery 104 or the low-voltage electronics battery 102.

The high-voltage traction battery 104 can include one or more high-voltage traction battery modules, such as can include a first high-voltage traction battery module 108, a second high-voltage traction battery module 110, and a third high-voltage traction battery module 112. Although three high-voltage traction battery modules are shown in FIG. 1, the high-voltage traction battery 104 can include any number of high-voltage traction battery modules, such as can include one, two, three, four, five, six, eight, ten, sixteen, thirty-two, or more high-voltage traction battery modules. The one or more high-voltage traction battery modules can form respective portions of the high-voltage traction battery 104. The one or more high-voltage traction battery modules can be coupled in series between a positive high-voltage traction battery terminal 114 and a negative high-voltage traction battery terminal 116. In an example, one or more of the high-voltage traction battery modules can be coupled in parallel. In an example, the high-voltage traction battery modules can be coupled in a combination of series and parallel arrangements. The high-voltage traction battery 104 can provide a voltage between the positive high-voltage traction battery terminal 114 and the negative high-voltage traction battery terminal 116, such as can include a voltage of 300 volts, 800 volts, or another voltage level specified for powering a vehicle drivetrain. One or more of the high-voltage traction battery module can include one or more cells 118 (e.g., lithium-ion cells, lithium iron phosphate cells, or other rechargeable battery cells). The cells 118 within a given high-voltage traction battery module can be coupled in series, in parallel, or in a combination of series and parallel arrangements.

One or more (e.g., each) of the wireless high-voltage battery cell modules can include respective high-voltage battery monitors 120, such as coupled to respective portions of the high-voltage traction battery 104 (e.g., the portions corresponding to the high-voltage traction battery module the battery monitor 120 is included in). For example, one high-voltage battery monitor 120 can be coupled to the cells 118 of the first high-voltage traction battery module 108, another high-voltage battery monitor 120 can be coupled to the cells 118 of the second high-voltage traction battery module 110, and another high-voltage battery monitor 120 can be coupled to the cells 118 of the third high-voltage traction battery module 112. One or more of the high-voltage battery monitors 120 can be configured to measure one or more parameters corresponding to the high-voltage traction battery 104, such as can include a voltage of one or more cells 118, a temperature of one or more cells 118, or a current flowing through one or more cells 118, or any other parameter. One or more of the high-voltage battery monitor 120 can also be configured to perform one or more operations on the cells 118, such as can include a cell balancing operation.

The respective high-voltage battery monitors 120 can be electrically isolated from one another. Because the high-voltage traction battery modules can be coupled in series, one or more of the high-voltage battery monitor 120 can operate at a distinct reference potential level. For example, a high-voltage battery monitor 120 coupled to the first high-voltage traction battery module 108 can operate at a reference potential level near the negative high-voltage traction battery terminal 116, while a high-voltage battery monitor 120 coupled to the third high-voltage traction battery module 112 can operate at a reference potential level that is hundreds of volts higher. The respective high-voltage battery monitors 120 can be powered by the corresponding respective portions of the high-voltage traction battery 104. For example, a high-voltage battery monitor 120 coupled to the first high-voltage traction battery module 108 can derive its operating power from the cells 118 of the first high-voltage traction battery module 108.

One or more of the wireless high-voltage battery cell module can include a power regulator 122 and a wireless node 124. The power regulator 122 can be configured to generate one or more regulated voltage levels from the cells 118 of the corresponding high-voltage traction battery module, the battery monitor 120, or another source, such as can include a 3.3 volt output or a 6 volt output. The power regulator 122 can provide operating power to the wireless node 124 and/or the high-voltage battery monitor 120. In an example, the battery monitor 120 can generate a first lower voltage from the cell 118 (e.g., 6 volts, such as to power the battery monitor 120), and the power regulator 122 can generate a second lower voltage (e.g., 3.3 volts) from this first lower voltage, such as to power the wireless node 124. The wireless node 124 can include a wireless transceiver, such as can be configured to transmit and receive electromagnetic signals, such as can include radio frequency signals. The wireless node 124 can be configured to wirelessly transmit data collected by the high-voltage battery monitor 120, such as can include voltage, current, or temperature parameters corresponding to the cells 118 of the corresponding high-voltage traction battery module. The high-voltage battery monitor 120 can communicate with the wireless node 124 using a wired connection, such as can include a Serial Peripheral Interface (SPI) bus.

The low-voltage electronics battery 102 can be included in a low-voltage electronics battery module, such as can include a network manager circuit 130, a low-voltage battery monitor 134, one or more cells 136, a FET driver 132, and FETs 138. The low-voltage electronics battery 102 can include the one or more cells 136. The low-voltage electronics battery 102 can provide a voltage suitable for powering electronic control units and other vehicle subsystems, such as can include a voltage of 12 volts, 24 volts, or 48 volts. The cells 136 can be lithium-ion cells, lithium iron phosphate cells, or other rechargeable battery cells. The low-voltage electronics battery can include a positive low-voltage electronics battery terminal 126 and a negative low-voltage electronics battery terminal 128. In an example, the low-voltage electronics battery can be used to replace a lead-acid battery that might otherwise be used to power vehicle electronics.

The network manager circuit 130 can be coupled to or included in (e.g., included in and in combination with) the automotive battery enclosure 106. The network manager circuit 130 can be included in the low-voltage electronics battery 102 (e.g., the low-voltage electronics battery module). The network manager circuit 130 can receive operating power from the low-voltage electronics battery, such as can include receiving a 12 volt DC input from the positive low-voltage electronics battery terminal 126 and the negative low-voltage electronics battery terminal 128. The network manager circuit 130 can operate using a reference potential level that matches or is close to a reference potential level of the low-voltage electronics battery, such as can include a reference potential level at or near 0 volts (e.g., automotive ground), such as can include within 15 volts of automotive ground.

The network manager circuit 130 can include a wireless transceiver configured to communicate wirelessly with the one or more high-voltage battery monitors 120 coupled to the high-voltage traction battery 104. For example, the wireless transceiver of the network manager circuit 130 can communicate with the wireless nodes 124 of the wireless high-voltage battery cell modules using electromagnetic signals within the automotive battery enclosure 106. The wireless transceiver can be configured to transmit and receive radio frequency signals, such as can include signals in the 2.4 GHz band or another frequency band. The automotive battery enclosure 106 can substantially shield the area outside the automotive battery enclosure 106 from the electromagnetic signals transmitted and received by the wireless transceiver, which can help reduce interference and can help improve wireless communication reliability within the automotive battery enclosure 106.

The network manager circuit 130 can include a first wired interface configured to communicate with the low-voltage battery monitor 134 coupled to the low-voltage electronics battery. The first wired interface can communicate with the low-voltage battery monitor 134 using a first wired connection 150, such as can include an SPI bus or another serial or parallel communication bus. The wired connection 150 can be contained within the low-voltage electronics battery 102. The wired connection 150 can be configured to receive one or more parameters corresponding to the low-voltage electronics battery 102 from the low-voltage battery monitor 134, such as can include a voltage of one or more cells 136, a current flowing through the low-voltage electronics battery 102 (e.g., measured using a shunt resistor 140), or a temperature of one or more cells 136. The wired connection 150 can also be configured to send one or more commands to the low-voltage battery monitor 134, such as can include a command to perform a cell balancing operation.

The low-voltage battery monitor 134 can be configured to measure one or more parameters of the cells 136, such as can include a voltage, a current, or a temperature. The low-voltage battery monitor 134 can communicate with the network manager circuit 130 using the wired connection 150. The shunt resistor 140 can be coupled in series with the low-voltage electronics battery 102 and can be configured to generate a voltage proportional to a current flowing through the low-voltage electronics battery 102. The low-voltage battery monitor 134 or the network manager circuit 130 can measure the voltage across the shunt resistor 140 to determine the current flowing through the low-voltage electronics battery 102.

The network manager circuit 130 can include a second wired interface configured to communicate with the BMS host controller 142. The second wired interface can communicate with the BMS host controller 142 using a second wired connection 146, such as can include an isoSPI (isolated Serial Peripheral Interface) bus or another serial or parallel communication bus. The second wired connection 146 can pass through the automotive battery enclosure 106, such as to reach the BMS host controller 142 external to the automotive battery enclosure 106. The first wired interface can be distinct from the second wired interface, or they can be the same interface. For example, the first wired interface can use a first communication protocol (e.g., SPI) and the second wired interface can use a second communication protocol (e.g., isoSPI), or the first wired interface and the second wired interface can use the same communication protocol but can be separate physical interfaces.

The second wired interface can be configured to transmit one or more parameters to the BMS host controller 142, such as can include a first parameter corresponding to the high-voltage traction battery 104 received from one or more high-voltage battery monitors 120 via the wireless transceiver, and a second parameter corresponding to the low-voltage electronics battery 102 received from the low-voltage battery monitor 134 via the first wired interface. In this way, the BMS host controller 142 can receive both high-voltage and low-voltage battery management data through a single wired interface without requiring a separate system or interface for the low-voltage electronics battery 102.

In an example, receiving a first parameter corresponding to the high-voltage traction battery 104 can include receiving, at the second wired interface, a first request for the first parameter from the BMS host controller 142 and sending, using the wireless transceiver, the first request to the high-voltage battery monitor 120. In an example, receiving a second parameter corresponding to the low-voltage electronics battery 102 can include receiving, at the second wired interface, a second request for the second parameter from the BMS host controller 142 and sending, using the first wired interface, the second request to the low-voltage battery monitor 134. In another example, the high-voltage battery monitors 120 and/or the low-voltage battery monitor 134 can be configured to periodically publish parameters according to a time schedule without requiring a request from the BMS host controller 142, such as can include publishing parameters every one second, every 100 milliseconds, or at another interval.

The network manager circuit 130 can be configured to receive a command from the BMS host controller 142 using the second wired interface and transmit the command to at least one of (1) the high-voltage battery monitor 120 through the wireless transceiver, or (2) the low-voltage battery monitor 134 through the first wired interface. The command can include at least one of a command to perform a cell balancing operation or a command to actuate a switch, such as can include a command to open or close the FETs 138. Other commands can include a command to change a reporting rate, a command to enter a sleep mode, a command to wake up, or another command.

The network manager circuit 130 can include a third wired interface configured to communicate with the FET driver 132. The third wired interface can be distinct from the first wired interface and the second wired interface, or one or more of the wired interfaces can be at least partially shared (e.g., sharing one or more components). The FET driver 132 can be a low-voltage battery switch driver configured to control a low-voltage battery switch. The low-voltage battery switch can include the FETs 138. The FETs 138 can be configured to isolate the low-voltage electronics battery when open. For example, the FETs 138 can be coupled in series with the low-voltage electronics battery 102 between the positive low-voltage electronics battery terminal 126 and the cells 136. When the FETs 138 are open (e.g., non-conducting), current flow from the low-voltage electronics battery to one or more loads (e.g., vehicle electronic control units) can be interrupted, which can help to isolate the low-voltage electronics battery. The FET driver 132 can receive control signals from the network manager circuit 130 via the third wired interface, such as can include via one or more SPI connections (e.g., over the wired connection 148). In an example, the FET driver 132 can be triggered to open the FETs 138 by one or more of the battery monitor 134 (e.g., directly through a wired connection, such as bypassing the network manager circuit 130), the network manager circuit 130 (e.g., locally, such as without requiring communication with the BMS host controller 142), or the BMS host controller 142, such as through the network manager circuit 130 (e.g., over the wired connection 146 and the wired connection 148). The FET driver 132 can generate one or more gate drive signals for controlling the FETs 138.

The BMS host controller 142 can be configured to monitor a fault condition of the low-voltage electronics battery. The BMS host controller 142 can be configured to trigger the low-voltage battery switch (e.g., the FETs 138) to open when the monitored fault condition indicates a fault is present. For example, the BMS host controller 142 can receive a parameter from the low-voltage battery monitor 134 (e.g., via the network manager circuit 130) indicating an overvoltage condition, an undervoltage condition, an overcurrent condition, an overtemperature condition, or another fault condition, and can send a command to the network manager circuit 130 to open the FETs 138 via the FET driver 132.

In an example, the network manager circuit 130 can be configured to monitor a fault condition of the low-voltage electronics battery. The network manager circuit 130 can be configured to trigger the low-voltage battery switch (e.g., the FETs 138) to open when the monitored fault condition indicates a fault is present, such as without requiring intervention from the BMS host controller 142. For example, the network manager circuit 130 can receive a parameter from the low-voltage battery monitor 134 indicating a fault condition and can send a command to the FET driver 132 to open the FETs 138 locally, without first communicating with the BMS host controller 142. This can allow for a faster response to fault conditions, such as can include responding within milliseconds, such as because the network manager circuit 130 does not have to send the parameter to the BMS host controller 142 and wait for a command to be returned. Local fault response by the network manager circuit 130 can also allow the low-voltage electronics battery to be protected when the BMS host controller 142 is not active, such as when a vehicle ignition is off and the BMS host controller 142 is in a sleep mode or is powered down (e.g., a "key-off" condition). The network manager circuit 130 can consume less power than the BMS host controller 142, which can help to allow the network manager circuit 130 to remain active and monitor the low-voltage electronics battery while the BMS host controller 142 is not active.

A connection between the low-voltage battery monitor 134 and the BMS host controller 142 through the network manager circuit 130 can meet a specified functional safety standard, such as can include an Automotive Safety Integrity Level (ASIL) standard or another functional safety standard. A connection between the FET driver 132 (e.g., the low-voltage battery switch driver) and the BMS host controller 142 through the network manager circuit 130 can meet the specified functional safety standard. The functional safety standard can be met using one or more of redundant data paths, error detection codes, periodic diagnostic messages, or other techniques. In an example, the functional safety standard can be met by the endpoints of the communication path (e.g., the low-voltage battery monitor 134 and the BMS host controller 142) each meeting the functional safety standard, such that data can be transmitted through the network manager circuit 130 while maintaining compliance with the functional safety standard.

The BMS host controller 142 can include a BMS Controller CPU 144. The BMS host controller 142 can be external to the automotive battery enclosure 106. The BMS host controller 142 can be configured to receive data from the network manager circuit 130 via the second wired connection 146 (e.g., isoSPI bus) passing through the automotive battery enclosure 106. The BMS host controller 142 can be configured to monitor and manage one or more of the high-voltage traction battery 104 or the low-voltage electronics battery 102, such as based on data received from the network manager circuit 130. The BMS host controller 142 can be a dedicated battery management controller or can be part of a larger vehicle controller that performs additional functions beyond battery management.

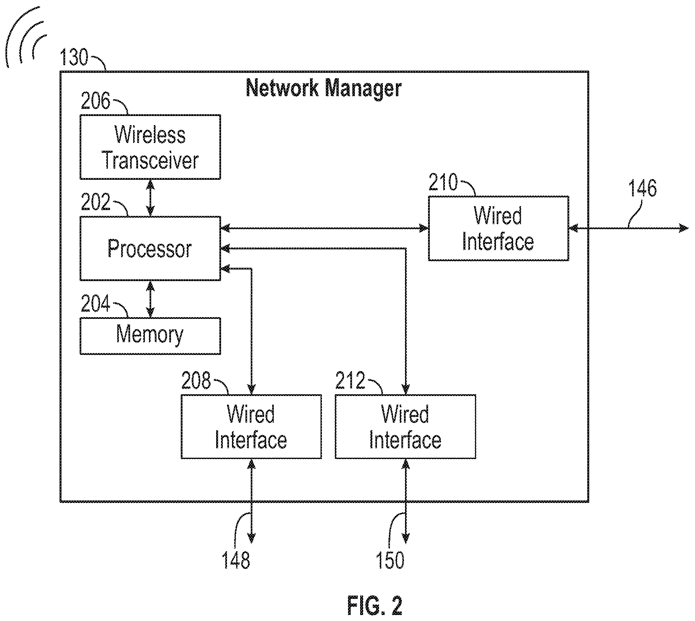

FIG. 2 shows a block diagram of an example of portions of the network manager circuit 130 and portions of an environment in which the network manager circuit 130 can be used. FIG. 2 shows that the network manager circuit 130 can include a processor 202, a memory 204, a wireless transceiver 206, and one or more wired interfaces, such as can include a wired interface 208, a wired interface 210, and a wired interface 212.

The processor 202 can be a microprocessor, a microcontroller, a digital signal processor, a field-programmable gate array, an application-specific integrated circuit, or another type of processing device. The processor 202 can be configured to execute instructions stored in the memory 204. The processor 202 can be coupled to the memory 204, the wireless transceiver 206, and the one or more wired interfaces 208, 210, 212. The processor 202 can be configured to receive data from the wireless transceiver 206, process the data, and provide the data to one or more of the wired interfaces 208, 210, 212. The processor 202 can also be configured to receive data or commands from one or more of the wired interfaces 208, 210, 212, process the data or commands, and provide the data or commands to the wireless transceiver 206 or to another one of the wired interfaces 208, 210, 212. The processor 202 can be configured to perform one or more local operations, such as can include monitoring a fault condition of the low-voltage electronics battery based on data received from the low-voltage battery monitor 134 via the wired interface 212 and triggering the FET driver 132 to open the FETs 138 via the wired interface 208, such as without requiring intervention from the BMS host controller 142.

The memory 204 can include one or more of a volatile memory (e.g., random access memory (RAM), static RAM, dynamic RAM), a non-volatile memory (e.g., flash memory, read-only memory (ROM), electrically erasable programmable ROM), or another type of memory. The memory 204 can store instructions executable by the processor 202, such as can include manager software configured to coordinate communication between the wireless transceiver 206 and the one or more wired interfaces 208, 210, 212. The memory 204 can also store data received from one or more of the wireless transceiver 206 or the wired interfaces 208, 210, 212, such as can include parameters corresponding to the high-voltage traction battery 104 or the low-voltage electronics battery. The memory 204 can store one or more fault thresholds, such as can include voltage thresholds, current thresholds, or temperature thresholds, that the processor 202 can use to determine whether a fault condition is present.

The wireless transceiver 206 can be configured to transmit and receive electromagnetic signals, such as can include radio frequency signals. The wireless transceiver 206 can be configured to communicate wirelessly with the one or more high-voltage battery monitors 120 of the wireless high-voltage battery cell modules described with reference to FIG. 1. For example, the wireless transceiver 206 can receive one or more parameters corresponding to the high-voltage traction battery 104 from the high-voltage battery monitors 120 via the wireless nodes 124. The wireless transceiver 206 can also transmit one or more commands to the high-voltage battery monitors 120 via the wireless nodes 124, such as can include a command to perform a cell balancing operation, a command to change a reporting rate, or another command. The wireless transceiver 206 can operate in a frequency band, such as can include the 2.4 GHz band or another frequency band.

The wired interface 212 can be a first wired interface configured to communicate with the low-voltage battery monitor 134 coupled to the low-voltage electronics battery. The wired interface 212 can use a communication protocol, such as can include SPI, I2C, UART, or another serial or parallel communication protocol. The wired interface 212 can be configured to receive one or more parameters corresponding to the low-voltage electronics battery from the low-voltage battery monitor 134, such as can include a voltage, a current, or a temperature. The wired interface 212 can also be configured to send one or more commands to the low-voltage battery monitor 134, such as can include a command to perform a cell balancing operation.

The wired interface 210 can be a second wired interface configured to communicate with the BMS host controller 142. The wired interface 210 can use a communication protocol, such as can include isoSPI, SPI, CAN, LIN, or another serial or parallel communication protocol. The wired interface 210 can be configured to transmit one or more parameters to the BMS host controller 142, such as can include a first parameter corresponding to the high-voltage traction battery 104 received from one or more high-voltage battery monitors 120 via the wireless transceiver 206, and a second parameter corresponding to the low-voltage electronics battery received from the low-voltage battery monitor 134 via the wired interface 212. The wired interface 210 can also be configured to receive one or more commands or requests from the BMS host controller 142, such as can include a request for a parameter, a command to perform a cell balancing operation, a command to actuate a switch, or another command. The wired interface 210 can be distinct from the wired interface 212. For example, the wired interface 210 can use a different communication protocol than the wired interface 212, or the wired interface 210 and the wired interface 212 can use the same communication protocol but can be separate physical interfaces.

The wired interface 208 can be a third wired interface configured to communicate with the FET driver 132. The wired interface 208 can use a communication protocol, such as can include SPI, I2C, UART, or another serial or parallel communication protocol. The wired interface 208 can be configured to send one or more control signals to the FET driver 132, such as can include a command to open or close the FETs 138. The wired interface 208 can be distinct from the wired interface 210 and the wired interface 212.

Although three wired interfaces 208, 210, 212 are shown in FIG. 2, the network manager circuit 130 can include any number of wired interfaces, such as can include one, two, three, four, five, or more wired interfaces. In an example, two or more of the wired interfaces can be combined into a single wired interface, such as can include a shared bus. In another example, one or more of the wired interfaces can be divided into two or more separate wired interfaces, such as can include separate physical connections for different functions.

The processor 202 can be configured to operate as a bridge between the wireless transceiver 206 and the one or more wired interfaces 208, 210, 212. For example, the processor 202 can receive a parameter from the wireless transceiver 206 (e.g., a parameter corresponding to the high-voltage traction battery 104) and can forward the parameter to the BMS host controller 142 via the wired interface 210. The processor 202 can receive a parameter from the wired interface 212 (e.g., a parameter corresponding to the low-voltage electronics battery) and can forward the parameter to the BMS host controller 142 via the wired interface 210. The processor 202 can receive a command from the BMS host controller 142 via the wired interface 210 and can forward the command to the high-voltage battery monitor 120 via the wireless transceiver 206 or to the low-voltage battery monitor 134 via the wired interface 212 or to the FET driver 132 via the wired interface 208. In this way, the network manager circuit 130 can provide a unified interface between the BMS host controller 142 and both the high-voltage traction battery 104 and the low-voltage electronics battery.

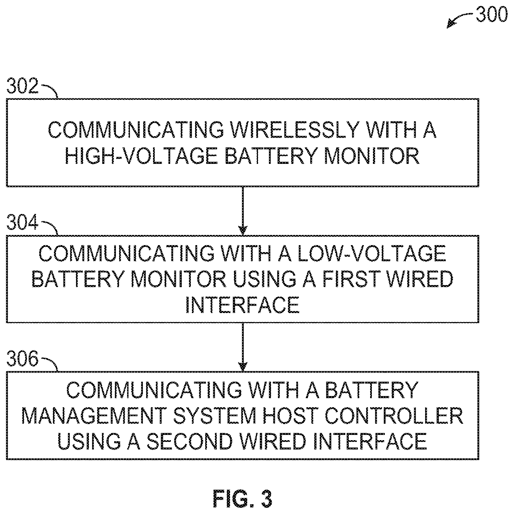

FIG. 3 is a flow diagram of an example of a method 300 for operating a battery management system for managing both a high-voltage traction battery and a low-voltage electronics battery, such as can be performed using the battery management system 100.

At step 302, the method 300 can include communicating, such as using a wireless transceiver, such as can be included in a network manager circuit, wirelessly with a high-voltage battery monitor which can be coupled to the high-voltage traction battery. For example, the wireless transceiver 206 of the network manager circuit 130 can communicate wirelessly with one or more high-voltage battery monitors 120 of the wireless high-voltage battery cell modules using electromagnetic signals within the automotive battery enclosure 106. Communicating wirelessly with the high-voltage battery monitor can include one or more of receiving one or more parameters corresponding to the high-voltage traction battery 104 from the high-voltage battery monitor 120 (e.g., a voltage, a current, or a temperature of one or more cells 118) or transmitting one or more commands to the high-voltage battery monitor 120 (e.g., a command to perform a cell balancing operation, a command to change a reporting rate, or another command). In an example, the high-voltage battery monitor 120 can periodically or recurrently publish parameters according to a time schedule, and communicating wirelessly can include receiving the published parameters at the wireless transceiver 206. In another example, communicating wirelessly can include sending a request for a parameter to the high-voltage battery monitor 120 and receiving the parameter in response to the request.

At step 304, the method 300 can include communicating, such as using a first wired interface, such as can be included in the network manager circuit, with a low-voltage battery monitor which can be coupled to the low-voltage electronics battery. For example, the wired interface 212 of the network manager circuit 130 can communicate with the low-voltage battery monitor 134 using a wired connection, such as can include an SPI bus. Communicating with the low-voltage battery monitor can include one or more of receiving one or more parameters corresponding to the low-voltage electronics battery 102 from the low-voltage battery monitor 134 (e.g., a voltage of one or more cells 136, a current flowing through the low-voltage electronics battery 102 as measured using the shunt resistor 140, or a temperature of one or more cells 136) or transmitting one or more commands to the low-voltage battery monitor 134 (e.g., a command to perform a cell balancing operation). In an example, the low-voltage battery monitor 134 can periodically or recurrently publish parameters according to a time schedule, and communicating with the low-voltage battery monitor can include receiving the published parameters at the wired interface 212. In another example, communicating with the low-voltage battery monitor can include sending a request for a parameter to the low-voltage battery monitor 134 and receiving the parameter in response to the request.

At step 306, the method 300 can include communicating, such as using a second wired interface, such as can be included in the network manager circuit, with a battery management system host controller. For example, the wired interface 210 of the network manager circuit 130 can communicate with the BMS host controller 142 using a wired connection, such as can include an isoSPI bus. Communicating with the BMS host controller can include one or more of transmitting one or more parameters to the BMS host controller 142 (e.g., a first parameter corresponding to the high-voltage traction battery 104 received at step 302 via the wireless transceiver 206, a second parameter corresponding to the low-voltage electronics battery received at step 304 via the first wired interface 212) or receiving one or more commands from the BMS host controller 142 (e.g., a command to perform a cell balancing operation, a command to actuate a switch, or another command). In an example, the second wired interface can pass through the automotive battery enclosure 106 to reach the BMS host controller 142 external to the automotive battery enclosure 106. In this way, the BMS host controller 142 can receive both high-voltage and low-voltage battery management data through a single wired interface without requiring a separate system or interface for the low-voltage electronics battery.

The shown order of steps 302, 304, 306 is not intended to be a limitation on the order in which the steps are performed. In an example, two or more of the steps can be performed simultaneously or at least partially concurrently. For example, the network manager circuit 130 can communicate wirelessly with the high-voltage battery monitor 120 at step 302 while also communicating with the low-voltage battery monitor 134 at step 304. In an example, the method 300 can be performed repeatedly, such as can include periodically or continuously during operation of the battery management system 100.

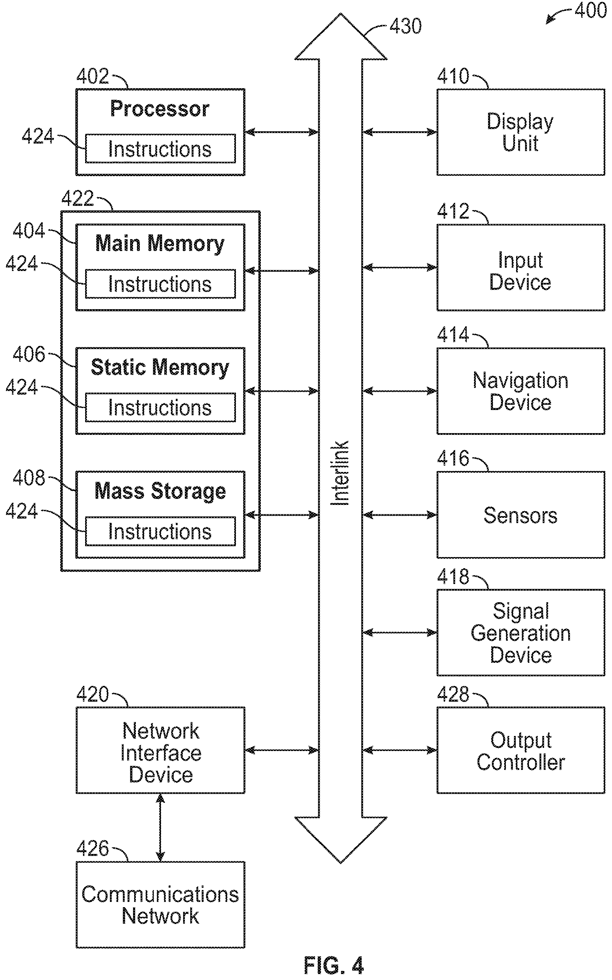

FIG. 4 illustrates a block diagram of an example machine 400 upon which any one or more of the techniques (e.g., methodologies) discussed herein may be implemented. Examples, as described herein, may include, or may operate by, logic or a number of components, or mechanisms in the machine 400. Circuitry (e.g., processing circuitry) is a collection of circuits implemented in tangible entities of the machine 400 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the machine 400 follow.

In alternative examples, the machine 400 may operate as a standalone device or may be connected (e.g., networked) to other machines. In a networked deployment, the machine 400 may operate in the capacity of a server machine, a client machine, or both in server-client network environments. In an example, the machine 400 may act as a peer machine in peer-to-peer (P2P) (or other distributed) network environment. The machine 400 may be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

The machine 400 may include a hardware processor 402 (e.g., a central processing unit (CPU), a graphics processing unit (GPU), a hardware processor core, or any combination thereof), a main memory 404, a static memory (e.g., memory or storage for firmware, microcode, a basic-input-output (BIOS), and mass storage 408 (e.g., hard drives, tape drives, flash storage, or other block devices) some or all of which may communicate with each other via an interlink 430 (e.g., bus). The machine 400 may further include a display unit 410, an alphanumeric input device 412 (e.g., a keyboard), and a user interface (UI) navigation device 414 (e.g., a mouse). In an example, the display unit 410, input device 412 and UI navigation device 414 may be a touch screen display. The machine 400 may additionally include a signal generation device 418 (e.g., a speaker), a network interface device 420, and one or more sensors 416, such as a global positioning system (GPS) sensor, compass, accelerometer, or other sensor. The machine 400 may include an output controller 428, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

Registers of the processor 402, the main memory 404, the static memory 406, or the mass storage 408 may be, or include, a machine readable medium 422 on which is stored one or more sets of data structures or instructions 424 (e.g., software) embodying or utilized by any one or more of the techniques or functions described herein. The instructions 424 may also reside, completely or at least partially, within any of registers of the processor 402, the main memory 404, the static memory 406, or the mass storage 408 during execution thereof by the machine 400. In an example, one or any combination of the hardware processor 402, the main memory 404, the static memory 406, or the mass storage 408 may constitute the machine readable media 422. While the machine readable medium 422 is illustrated as a single medium, the term "machine readable medium" may include a single medium or multiple media (e.g., a centralized or distributed database, and/or associated caches and servers) configured to store the one or more instructions 424.

The term "machine readable medium" may include any medium that is capable of storing, encoding, or carrying instructions for execution by the machine 400 and that cause the machine 400 to perform any one or more of the techniques of the present disclosure, or that is capable of storing, encoding or carrying data structures used by or associated with such instructions. Non-limiting machine readable medium examples may include solid-state memories, optical media, magnetic media, and signals (e.g., radio frequency signals, other photon based signals, sound signals, etc.). In an example, a non-transitory machine readable medium comprises a machine readable medium with a plurality of particles having invariant (e.g., rest) mass, and thus are compositions of matter. Accordingly, non-transitory machine-readable media are machine readable media that do not include transitory propagating signals. Specific examples of non-transitory machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; and CD-ROM and DVD-ROM disks.

In an example, information stored or otherwise provided on the machine readable medium 422 may be representative of the instructions 424, such as instructions 424 themselves or a format from which the instructions 424 may be derived. This format from which the instructions 424 may be derived may include source code, encoded instructions (e.g., in compressed or encrypted form), packaged instructions (e.g., split into multiple packages), or the like. The information representative of the instructions 424 in the machine readable medium 422 may be processed by processing circuitry into the instructions to implement any of the operations discussed herein. For example, deriving the instructions 424 from the information (e.g., processing by the processing circuitry) may include: compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions 424.

In an example, the derivation of the instructions 424 may include assembly, compilation, or interpretation of the information (e.g., by the processing circuitry) to create the instructions 424 from some intermediate or preprocessed format provided by the machine readable medium 422. The information, when provided in multiple parts, may be combined, unpacked, and modified to create the instructions 424. For example, the information may be in multiple compressed source code packages (or object code, or binary executable code, etc.) on one or several remote servers. The source code packages may be encrypted when in transit over a network and decrypted, uncompressed, assembled (e.g., linked) if necessary, and compiled or interpreted (e.g., into a library, stand-alone executable etc.) at a local machine, and executed by the local machine.

The instructions 424 may be further transmitted or received over a communications network 426 using a transmission medium via the network interface device 420 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), LoRa/LoRaWAN, or satellite communication networks, mobile telephone networks (e.g., cellular networks such as those complying with 3G, 4G LTE/LTE-A, or 5G standards), Plain Old Telephone (POTS) networks, and wireless data networks (e.g., Institute of Electrical and Electronics Engineers (IEEE) 802.11 family of standards known as Wi-Fi^{®}, IEEE 802.15.4 family of standards, peer-to-peer (P2P) networks, among others. In an example, the network interface device 420 may include one or more physical jacks (e.g., Ethernet, coaxial, or phone jacks) or one or more antennas to connect to the communications network 426. In an example, the network interface device 420 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 400, and includes digital or analog communications signals or other intangible medium to facilitate communication of such software. A transmission medium is a machine-readable medium.

The following, non-limiting examples, detail certain aspects of the present subject matter to solve the challenges and provide the benefits discussed herein, among others.

### Examples:

Example 1 is a battery management system for managing both a high-voltage traction battery and a low-voltage electronics battery, the battery management system comprising: a network manager circuit including: a wireless transceiver, configured to communicate wirelessly with a high-voltage battery monitor coupled to the high-voltage traction battery; a first wired interface, configured to communicate with a low-voltage battery monitor coupled to the low-voltage electronics battery; and a second wired interface, configured to communicate with a battery management system host controller.

In Example 2, the subject matter of Example 1 optionally includes wherein: the wireless transceiver is configured to receive a first parameter corresponding to the high-voltage traction battery from the high-voltage battery monitor; the first wired interface is configured to receive a second parameter corresponding to the low-voltage electronics battery from the low-voltage battery monitor; and the second wired interface is configured to transmit the first parameter and the second parameter to the battery management system host controller.

In Example 3, the subject matter of Example 2 optionally includes wherein: receiving the first parameter includes receiving, at the second wired interface, a first request for the first parameter from the battery management system host controller and sending, using the wireless transceiver, the first request to the high-voltage battery monitor; and receiving the second parameter includes receiving, at the second wired interface, a second request for the second parameter from the battery management system host controller and sending, using the first wired interface, the second request to the low-voltage battery monitor.

In Example 4, the subject matter of any one or more of Examples 2-3 optionally include wherein: the first parameter includes at least one of a voltage, current, or temperature corresponding to the high-voltage traction battery; and the second parameter includes at least one of a voltage, current, or temperature corresponding to the low-voltage electronics battery.

In Example 5, the subject matter of any one or more of Examples 1-4 optionally include wherein: the network manager circuit is configured to: receive a command from the battery management system host controller using the second wired interface; and transmit the command to at least one of (1) the high-voltage battery monitor through the wireless transceiver, or (2) the low-voltage battery monitor through the first wired interface.

In Example 6, the subject matter of Example 5 optionally includes wherein: the command includes at least one of a command to perform a cell balancing operation or a command to actuate a switch.

In Example 7, the subject matter of any one or more of Examples 1-6 optionally include wherein: the network manager circuit is included in and in combination with an automotive battery enclosure including the high-voltage traction battery and the low-voltage electronics battery.

In Example 8, the subject matter of Example 7 optionally includes wherein the network manager circuit is included in and in combination with a low-voltage electronics battery module including the low-voltage electronics battery.

In Example 9, the subject matter of Example 8 optionally includes wherein: the automotive battery enclosure substantially shields an area outside the automotive battery enclosure from electromagnetic signals transmitted and received by the wireless transceiver; the wireless transceiver communicates with the high-voltage battery monitor using electromagnetic signals within the automotive battery enclosure; the first wired interface communicates with the low-voltage battery monitor using a first wired connection, the first wired connection contained within the low-voltage electronics battery module; and the second wired interface communicates with the battery management system host controller using a second wired connection, the second wired connection passing through the automotive battery enclosure to reach the battery management system host controller external to the automotive battery enclosure.

In Example 10, the subject matter of any one or more of Examples 7-9 optionally include the low-voltage electronics battery; the high-voltage traction battery; and the automotive battery enclosure.

In Example 11, the subject matter of any one or more of Examples 1-10 optionally include wherein: the high-voltage traction battery includes two or more high-voltage traction battery modules comprising respective portions of the high-voltage traction battery; the two or more high-voltage traction battery modules include respective high-voltage battery monitors, coupled to the respective portions of the high-voltage traction battery; and the respective high-voltage battery monitors are configured to communicate wirelessly with the wireless transceiver.

In Example 12, the subject matter of Example 11 optionally includes wherein: the respective high-voltage battery monitors are electrically isolated from one another; the respective high-voltage battery monitors operate at distinct reference potential levels; and the respective high-voltage battery monitors are powered by the corresponding respective portions of the high-voltage traction battery.

In Example 13, the subject matter of any one or more of Examples 1-12 optionally include wherein the network manager circuit includes: a third wired interface, configured to communicate with a low-voltage battery switch driver, the low-voltage battery switch driver configured to control a low-voltage battery switch, the low-voltage battery switch configured to isolate the low-voltage electronics battery when open.

In Example 14, the subject matter of Example 13 optionally includes wherein: the battery management system host controller is configured to monitor a fault condition of the low-voltage electronics battery; and the battery management system host controller is configured to trigger the low-voltage battery switch to open when the monitored fault condition indicates a fault is present.

In Example 15, the subject matter of any one or more of Examples 13-14 optionally include wherein: the network manager circuit is configured to monitor a fault condition of the low-voltage electronics battery; and the network manager circuit is configured to trigger the low-voltage battery switch to open when the monitored fault condition indicates a fault is present.

In Example 16, the subject matter of any one or more of Examples 13-15 optionally include wherein: a connection between the low-voltage battery monitor and the battery management system host controller through the network manager circuit meets a specified functional safety standard; and a connection between the low-voltage battery switch driver and the battery management system host controller through the network manager circuit meets the specified functional safety standard.

In Example 17, the subject matter of any one or more of Examples 1-16 optionally include wherein: the first wired interface is distinct from the second wired interface.

Example 18 is a method of operating a battery management system for managing both a high-voltage traction battery and a low-voltage electronics battery, the method comprising: communicating, using a wireless transceiver included in a network manager circuit, wirelessly with a high-voltage battery monitor coupled to the high-voltage traction battery; communicating, using a first wired interface included in the network manager circuit, with a low-voltage battery monitor coupled to the low-voltage electronics battery; and communicating, using a second wired interface included in the network manager circuit, with a battery management system host controller.

In Example 19, the subject matter of Example 18 optionally includes receiving, using the wireless transceiver, a first parameter corresponding to the high-voltage traction battery from the high-voltage battery monitor; receiving, using the first wired interface, a second parameter corresponding to the low-voltage electronics battery from the low-voltage battery monitor; and transmitting, using the second wired interface, the first parameter and the second parameter to the battery management system host controller.

Example 20 is a battery management system for managing both a high-voltage traction battery and a low-voltage electronics battery, the battery management system comprising: a network manager circuit included in and in combination with an automotive battery enclosure including the high-voltage traction battery and the low-voltage electronics battery, the network manager circuit including: a wireless transceiver, configured to communicate wirelessly with a high-voltage battery monitor coupled to the high-voltage traction battery; a first wired interface, configured to communicate with a low-voltage battery monitor coupled to the low-voltage electronics battery; and a second wired interface, configured to communicate with a battery management system host controller; and the battery management system host controller external to the automotive battery enclosure, wherein the second wired interface passes through the automotive battery enclosure.

Example 21 is at least one machine-readable medium including instructions that, when executed by processing circuitry, cause the processing circuitry to perform operations to implement of any of Examples 1-20.

Example 22 is an apparatus comprising means to implement of any of Examples 1-20.

Example 23 is a system to implement of any of Examples 1-20.

Example 24 is a method to implement of any of Examples 1-20.

Each of the non-limiting aspects above can stand on its own or can be combined in various permutations or combinations with one or more of the other aspects or other subject matter described in this document.

The above detailed description includes references to the accompanying drawings, which form a part of the detailed description. The drawings show, by way of illustration, specific examples that may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the terms "or" and "and/or" are used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The term "about," as used herein, means approximately, in the region of, roughly, or around. When the term "about" is used in conjunction with a numerical range, it modifies that range by extending the boundaries above and below the numerical values set forth. In general, the term "about" is used herein to modify a numerical value above and below the stated value by a variance of 10%. In one aspect, the term "about" means plus or minus 10% of the numerical value of the number with which it is being used. Therefore, about 50% means in the range of 45%-55%. Numerical ranges recited herein by endpoints include all numbers and fractions subsumed within that range (e.g., 1 to 5 includes 1, 1.5, 2, 2.75, 3, 3.90, 4, 4.24, and 5). Similarly, numerical ranges recited herein by endpoints include subranges subsumed within that range (e.g., 1 to 5 includes 1-1.5, 1.5-2, 2-2.75, 2.75-3, 3-3.90, 3.90-4, 4-4.24, 4.24-5, 2-5, 3-5, 1-4, and 2-4).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Such instructions can be read and executed by one or more processors to enable performance of operations comprising a method, for example. The instructions are in any suitable form, such as but not limited to source code, compiled code, interpreted code, executable code, static code, dynamic code, and the like.

Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other examples may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment. The scope of the examples should be determined with reference to the appended claims, along with the full scope of equivalents to which such claims are entitled.

## Claims

1. A battery management system for managing both a high-voltage traction battery and a low-voltage electronics battery, the battery management system comprising:
a network manager circuit including:
a wireless transceiver, configured to communicate wirelessly with a high-voltage battery monitor coupled to the high-voltage traction battery;
a first wired interface, configured to communicate with a low-voltage battery monitor coupled to the low-voltage electronics battery; and
a second wired interface, configured to communicate with a battery management system host controller.

2. The battery management system of claim 1, wherein:
the wireless transceiver is configured to receive a first parameter corresponding to the high-voltage traction battery from the high-voltage battery monitor;
the first wired interface is configured to receive a second parameter corresponding to the low-voltage electronics battery from the low-voltage battery monitor; and
the second wired interface is configured to transmit the first parameter and the second parameter to the battery management system host controller,
preferably wherein:
receiving the first parameter includes receiving, at the second wired interface, a first request for the first parameter from the battery management system host controller and sending, using the wireless transceiver, the first request to the high-voltage battery monitor; and
receiving the second parameter includes receiving, at the second wired interface, a second request for the second parameter from the battery management system host controller and sending, using the first wired interface, the second request to the low-voltage battery monitor.

3. The battery management system of claim 2, wherein:
the first parameter includes at least one of a voltage, current, or temperature corresponding to the high-voltage traction battery; and
the second parameter includes at least one of a voltage, current, or temperature corresponding to the low-voltage electronics battery.

4. The battery management system of any preceding claim, wherein: the network manager circuit is configured to:
receive a command from the battery management system host controller using the second wired interface; and
transmit the command to at least one of (1) the high-voltage battery monitor through the wireless transceiver, or (2) the low-voltage battery monitor through the first wired interface,
preferably wherein:
the command includes at least one of a command to perform a cell balancing operation or a command to actuate a switch.

5. The battery management system of any preceding claim, wherein:
the network manager circuit is included in and in combination with an automotive battery enclosure including the high-voltage traction battery and the low-voltage electronics battery,
preferably wherein the network manager circuit is included in and in combination with a low-voltage electronics battery module including the low-voltage electronics battery.

6. The battery management system of claim 5, wherein:
the automotive battery enclosure substantially shields an area outside the automotive battery enclosure from electromagnetic signals transmitted and received by the wireless transceiver;
the wireless transceiver communicates with the high-voltage battery monitor using electromagnetic signals within the automotive battery enclosure;
the first wired interface communicates with the low-voltage battery monitor using a first wired connection, the first wired connection contained within the low-voltage electronics battery module; and
the second wired interface communicates with the battery management system host controller using a second wired connection, the second wired connection passing through the automotive battery enclosure to reach the battery management system host controller external to the automotive battery enclosure.

7. The battery management system of claim 5 or 6, further comprising:
the low-voltage electronics battery;
the high-voltage traction battery; and
the automotive battery enclosure.

8. The battery management system of any preceding claim, wherein:
the high-voltage traction battery includes two or more high-voltage traction battery modules comprising respective portions of the high-voltage traction battery;
the two or more high-voltage traction battery modules include respective high-voltage battery monitors, coupled to the respective portions of the high-voltage traction battery; and
the respective high-voltage battery monitors are configured to communicate wirelessly with the wireless transceiver,
preferably wherein:
the respective high-voltage battery monitors are electrically isolated from one another;
the respective high-voltage battery monitors operate at distinct reference potential levels; and
the respective high-voltage battery monitors are powered by the corresponding respective portions of the high-voltage traction battery.

9. The battery management system of any preceding claim, wherein the network manager circuit includes:
a third wired interface, configured to communicate with a low-voltage battery switch driver, the low-voltage battery switch driver configured to control a low-voltage battery switch, the low-voltage battery switch configured to isolate the low-voltage electronics battery when open,
preferably wherein:
the battery management system host controller is configured to monitor a fault condition of the low-voltage electronics battery; and
the battery management system host controller is configured to trigger the low-voltage battery switch to open when the monitored fault condition indicates a fault is present.

10. The battery management system of claim 9, wherein:
the network manager circuit is configured to monitor a fault condition of the low-voltage electronics battery; and
the network manager circuit is configured to trigger the low-voltage battery switch to open when the monitored fault condition indicates a fault is present.

11. The battery management system of claim 9 or 10, wherein:
a connection between the low-voltage battery monitor and the battery management system host controller through the network manager circuit meets a specified functional safety standard; and
a connection between the low-voltage battery switch driver and the battery management system host controller through the network manager circuit meets the specified functional safety standard.

12. The battery management system of any preceding claim, wherein:
the first wired interface is distinct from the second wired interface.

13. A method of operating a battery management system for managing both a high-voltage traction battery and a low-voltage electronics battery, the method comprising:
communicating, using a wireless transceiver included in a network manager circuit, wirelessly with a high-voltage battery monitor coupled to the high-voltage traction battery;
communicating, using a first wired interface included in the network manager circuit, with a low-voltage battery monitor coupled to the low-voltage electronics battery; and
communicating, using a second wired interface included in the network manager circuit, with a battery management system host controller.

14. The method of claim 13, comprising:
receiving, using the wireless transceiver, a first parameter corresponding to the high-voltage traction battery from the high-voltage battery monitor;
receiving, using the first wired interface, a second parameter corresponding to the low-voltage electronics battery from the low-voltage battery monitor; and
transmitting, using the second wired interface, the first parameter and the second parameter to the battery management system host controller.

15. A battery management system for managing both a high-voltage traction battery and a low-voltage electronics battery, the battery management system comprising:
a network manager circuit included in and in combination with an automotive battery enclosure including the high-voltage traction battery and the low-voltage electronics battery, the network manager circuit including:
a wireless transceiver, configured to communicate wirelessly with a high-voltage battery monitor coupled to the high-voltage traction battery;
a first wired interface, configured to communicate with a low-voltage battery monitor coupled to the low-voltage electronics battery; and
a second wired interface, configured to communicate with a battery management system host controller; and
the battery management system host controller external to the automotive battery enclosure, wherein the second wired interface passes through the automotive battery enclosure.
